# FASCICULE DE BREVET EUROPEEN

(11) **EP 2 084 632 B1**
(45) Date de publication et mention de la délivrance du brevet: **28.09.2011**
(21) Numéro de dépôt: 07866430.7
(22) Date de dépôt: 24.10.2007
(51) Int. Cl.: G06F 17/50, B64C 27/00

(54) **PROCEDE ET DISPOSITIFS D'AIDE AU POSITIONNEMENT RELATIF D'OBJETS DURANT UNE PHASE DE CONCEPTION**
VERFAHREN UND HILFE ZUR RELATIVEN POSITIONIERUNG VON OBJEKTEN WÄHREND EINER ENTWURFSPHASE
METHOD AND AIDS FOR RELATIVE POSITIONING OF OBJECTS DURING A DESIGN PHASE

(30) Priorité: 27.10.2006 FR 0654600
(43) Date de publication de la demande: 05.08.2009
(73) Titulaire: Airbus Operations, 31060 Toulouse (FR)
(72) Inventeur: CAZALS, Olivier, 31700 Daux (FR)
(74) Mandataire: Petit, Maxime
(86) Numéro de dépôt international: PCT/FR2007/001756
(87) Numéro de publication internationale: WO 2008/056055

(56) Documents cités:
- EP-A- 1 056 026
- WO-A-99/28849
- WO-A-2004/010384
- WO-A-2005/111797
- GB-A- 2 292 657
- US-A- 5 754 738
- US-A1- 2005 209 830
- US-B1- 6 385 563
- SATOSHI TANAKA ET AL: "A Visual Intersection ebugger for Modeling Geant4 Detector Geometry - David -" COMPUTING IN HIGH ENERGY PHYSICS, XX, XX, 1998, pages 1-4, XP002427236
- AGOSTINELLI S ET AL: "Geant4-a simulation toolkit" NUCLEAR INSTRUMENTS & METHODS IN PHYSICS RESEARCH, SECTION - A: ACCELERATORS, SPECTROMETERS, DETECTORS AND ASSOCIATED EQUIPMENT, ELSEVIER, AMSTERDAM, NL, vol. 506, no. 3, 1 juillet 2003 (2003-07-01), pages 250-303, XP004431463 ISSN: 0168-9002

## Description

La présente invention concerne la conception d'objets tridimensionnels composés de plusieurs éléments et, plus particulièrement, un procédé et des dispositifs d'aide au positionnement, lors d'une phase de conception, d'un premier objet relativement à un second objet selon un ensemble de contraintes géométriques et mathématiques.

La conception d'ensembles complexes, tels que des avions, exige le positionnement relatif de plusieurs éléments. Le positionnement d'un premier élément par rapport à un second fait généralement intervenir des corps de métier différents: Par exemple, le positionnement d'un moteur sur une aile d'avion exige la consultation de motoristes, de mécaniciens, d'aérodynamiciens, d'acousticiens et de spécialistes de nombreux autres métiers.

De façon traditionnelle, l'étude de positionnement est organisée sous forme d'analyses partielles successives. Les spécialistes des corps de métier dont les conséquences liées au choix du positionnement sont les plus importantes, selon des critères prédéterminés, sont chargés de commencer l'étude et de proposer une première position. L'étude est alors transmise à un spécialiste d'un autre corps de métier qui va la compléter, et ainsi de suite. Lorsque tous les corps de métier ont participés à l'étude, le dossier est généralement retransmis à chacun d'eux pour valider le résultat. Si le positionnement a été modifié au cours de l'étude et que certains critères, pour un corps de métier particulier, ne sont plus remplis, il est nécessaire de modifier le positionnement et de répéter la succession d'analyses partielles, auprès de tous les corps de métier, pour valider la nouvelle position.

En raison du nombre de corps de métier différents intervenant, il n'est généralement pas possible de gérer dynamiquement le processus. Il en résulte donc des délais importants et un manque de vue d'ensemble du processus qui permettrait à chaque corps de métier d'appréhender de façon simple la problématique des autres corps de métier.

Le document intitulé « A visual intersection debugger for modeling Geant4 detector geometry - David - », Satoshi Tanaka et Al., Computing in high energy physics, 1998, pages 1-4, décrit un système d'analyse et de visualisation d'objets géométriques tridimensionnels représentant des composants de détection de particules pour identifier des intersections entre ces objets.

Bien qu'une telle solution permette d'identifier un problème de placement d'objets selon une contrainte propre à la position et à la forme de ces objets, il existe néanmoins un besoin pour optimiser le placement d'un premier objet par rapport à un second objet dans un environnement complexe, comportant un ensemble de contraintes, et faisant intervenir des corps de métier différents.

L'invention permet de résoudre au moins un des problèmes exposés précédemment.

L'invention a ainsi pour objet un procédé d'aide au positionnement d'un premier objet relativement à un second objet selon au moins une contrainte liée à la position relative des premier et second objets, le procédé étant caractérisé en ce que ledit premier objet comprenant au moins une partie d'un ensemble propulsif pour aéronef et ladite au moins une contrainte étant liée à l'aérodynamique d'au moins une partie dudit premier objet, aux pièces mobiles d'au moins une partie dudit premier objet, au risque d'éclatement d'au moins une partie dudit premier objet ou au bruit ou à la chaleur pouvant être émis par au moins une partie dudit premier objet, le procédé comprend les étapes suivantes,
- sélection d'un modèle paramétrique associé à chacun des premier et second objets ;
- affichage d'un modèle numérique du second objet selon le modèle paramétrique associé au second objet ;
- positionnement du premier objet relativement au second objet selon des paramètres des modèles paramétriques associés aux premier et second objets ;
- affichage d'un modèle numérique du premier objet selon le modèle paramétrique associé au premier objet et selon le positionnement ;
- sélection d'au moins un modèle paramétrique comprenant une modélisation de la au moins une contrainte ;
- pour le au moins un modèle paramétrique comprenant une modélisation de la au moins une contrainte,
   ■ acquisition d'au moins une donnée liée à la position d'au moins l'un des premier et second objets ;
   ■ évaluation de la au moins une contrainte selon la au moins une donnée.

Le procédé selon l'invention permet de conduire une étude de positionnement riche en nombre de paramètres et de contraintes, utilisant une interface simple. En outre, le procédé est ouvert aux contraintes futures qui peuvent être aisément ajoutées à l'étude.

De préférence, le procédé comprend en outre une étape de modification d'au moins un paramètre d'au moins un des modèles paramétriques associés aux premier et second objets, les étapes de,
■ acquisition d'au moins une donnée liée à la position d'au moins l'un des premier et second objets ; et,
■ évaluation de la au moins une contrainte selon la au moins une donnée,
étant ré-exécutées pour le au moins un modèle paramétrique comprenant une modélisation de la au moins une contrainte, après la modification du au moins un paramètre. La gestion dynamique et associative des objets et des contraintes permet à l'utilisateur d'optimiser le positionnement d'un objet selon un ensemble important de contraintes par une analyse rapide des effets des modifications sur les contraintes.

Dans un mode de réalisation particulier, le procédé comprend en outre une étape d'affichage du résultat de l'évaluation de la au moins une contrainte. De préférence, l'affichage comprend l'affichage d'une indication graphique associée à la au moins une contrainte de telle sorte qu'une analyse visuelle de la position de l'indication graphique relativement à au moins l'un des modèles numériques associés aux premier et second objets permette de valider la position du premier objet selon la au moins une contrainte. De façon alternative ou complémentaire, l'affichage comprend l'affichage d'une moins une valeur permettant de valider la position du premier objet selon ladite au moins une contrainte.

Toujours selon un mode de réalisation particulier, le modèle paramétrique comprenant une modélisation de la au moins une contrainte est compris dans l'un des modèles paramétriques associés aux premier et second objets. Alternativement, au moins une donnée du au moins un modèle paramétrique comprenant une modélisation de la au moins une contrainte est importée de l'un des modèles paramétriques associés aux premier et second objets. La modélisation des contraintes dans les modèles paramétriques des objets à positionner ou l'utilisation de données spécifiques des modèles paramétriques associés aux premier et second objets permet une organisation fonctionnelle des modèles paramétriques ainsi que de réduire le nombre de paramètres des modèles paramétriques à ceux qui sont nécessaires.

Selon un mode de réalisation particulier, le second objet comprend au moins une partie d'un aéronef.

Toujours selon un mode de réalisation particulier, la au moins une contrainte est liée à au moins l'une des positions suivantes : position des portes, position des toboggans, position du sol, position relative du sol lors d'un atterrissage par vent de travers et position relative du sol lors d'un atterrissage avec le train d'atterrissage avant effacé.

L'invention a aussi pour objet un procédé pour un dispositif comprenant des moyens adaptés à la mise en oeuvre de chacune des étapes du procédé décrit précédemment.

L'invention a également pour objet un programme d'ordinateur comprenant des instructions adaptées à la mise en oeuvre de chacune des étapes du procédé décrit précédemment.

D'autres avantages, buts et caractéristiques de la présente invention ressortent de la description détaillée qui suit, faite à titre d'exemple non limitatif, au regard des dessins annexés dans lesquels :
- la figure 1 montre un exemple d'appareil permettant d'implémenter l'invention ;
- la figure 2 illustre schématiquement un exemple de l'environnement d'étude du positionnement d'un ensemble propulsif sur un avion, selon l'invention, ainsi que les relations entre cette étude et les corps de métier impliqués ;
- la figure 3 illustre un exemple de mécanisme d'instanciation de modèle paramétrique générique à partir d'un modèle instancié ;
- la figure 4 représente un avion, le repère géométrique utilisé ainsi que les limites liées au sol par atterrissage avec le train d'atterrissage avant effacé et à l'ouverture des portes ;
- la figure 5 illustre une vue de côté d'un avion sur une aile duquel une nacelle a été positionnée ainsi que les plans de limites des toboggans et de limites de porte ;
- la figure 6 illustre le positionnement d'une nacelle sous une aile d'avion permettant une analyse visuelle de cette position par rapport aux limites aérodynamiques de surpression ;
- la figure 7, comprenant les figures 7a et 7b, illustre la validation du positionnement de la nacelle selon les contraintes liées à l'inversion de la poussée, et selon les contraintes liées à l'ouverture des capots du moteur pour sa maintenance, respectivement ;
- la figure 8 représente un mât filaire reliant un ensemble propulsif à une aile d'avion ;
- la figure 9 illustre un cône d'éclatement de pales de turbine ; et,
- la figure 10 représente schématiquement certaines étapes d'un exemple de mise en oeuvre de l'invention.

Le procédé de l'invention est un outil de validation 3D destiné, en particulier, à la réalisation d'études d'installations motrices sur des avions conventionnels ou non. Selon une implémentation particulière, le procédé utilise le logiciel de conception 3D Catia pour assurer l'associativité de modèles géométriques entre eux et un éditeur de paramètres pour modifier la valeur de paramètres des modèles géométriques. La description suivante illustre la mise en oeuvre de l'invention dans ce contexte cependant, il doit être compris que l'invention ne se limite pas à cette implémentation particulière.

Catia, développé par la société française Dassault Systèmes et commercialisé par la société IBM, est un logiciel de conception assistée par ordinateur (CAO), orienté 3D dans lequel toutes les étapes du développement d'un produit peuvent être gérées.

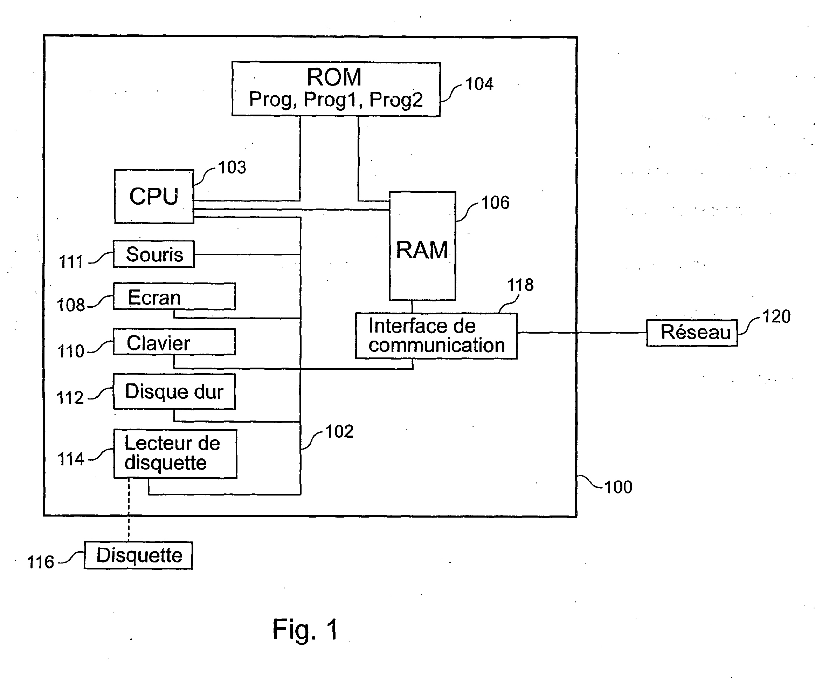

La figure 1 illustre un exemple d'appareil 100 adapté à mettre en oeuvre l'invention, tel qu'un micro-ordinateur ou une station de travail.

De préférence, l'appareil 100 comporte un bus de communication 102 auquel sont reliés,
- une unité centrale de traitement 103 telle qu'un microprocesseur ;
- une mémoire morte 104 ou *Read Only Memory* (ROM), pouvant comporter un ou plusieurs programmes "Prog", "Prog1" et "Prog2" ;
- une mémoire vive 106 ou *Random Access Memrory* (RAM), comportant des registres adaptés à mémoriser des variables et des paramètres créés et modifiés au cours de l'exécution des programmes précités ; et
- une interface de communication 118 reliée à un réseau de communication distribué 120, par exemple le réseau intranet, l'interface étant apte à transmettre et à recevoir des données.

L'appareil 100 peut disposer optionnellement de l'un, de plusieurs ou de tous les dispositifs suivants :
- un écran 108 permettant de visualiser des données et/ou de servir d'interface graphique avec l'utilisateur qui pourra interagir avec les programmes selon l'invention, à l'aide d'un clavier 110 ou de tout autre moyen tel qu'un dispositif de pointage, comme par exemple une souris 111 ou un crayon optique, un écran tactile ou une télécommande ;
- un disque dur 112 pouvant comporter des programmes et/ou des données, notamment des données traitées ou à traiter selon l'invention ;
- un lecteur de disquette 114 adapté à recevoir une disquette 116 et à y lire ou à y écrire des données traitées ou à traiter selon l'invention ; et,
- un lecteur de cartes mémoire adapté à y lire ou à y écrire des données, notamment des données traitées ou à traiter selon l'invention.

Le bus de communication permet la communication et l'interopérabilité entre les différents éléments inclus dans l'appareil 100 ou reliés à lui. La représentation du bus n'est pas limitative et, notamment, l'unité centrale est susceptible de communiquer des instructions à tout élément de l'appareil 100, directement ou par l'intermédiaire d'un autre élément de l'appareil 100.

Le code exécutable du ou des programme(s) permettant à l'appareil 100 de mettre en oeuvre les processus selon l'invention, peut être stocké, par exemple, dans le disque dur 112 ou en mémoire morte 104.

Selon une variante, la disquette 116, peut contenir des données ainsi que le code exécutable des programmes précités qui, une fois lu par l'appareil 100, peuvent être stockés dans le disque dur 112.

Alternativement, le code exécutable des programmes peut être reçu par l'intermédiaire du réseau de communication 120, via l'interface 118, pour être stocké de façon identique à celle décrite précédemment.

Les disquettes peuvent être remplacées par tout support d'information tel que, par exemple, un disque compact (CD-ROM) ou une carte mémoire. De manière générale, un moyen de stockage d'information, lisible par Un ordinateur ou par un microprocesseur, intégré ou non à l'appareil, éventuellement amovible, est adapté à mémoriser un ou plusieurs programmes dont l'exécution permet la mise en oeuvre du procédé selon l'invention.

De manière plus générale, le ou les programmes pourront être chargés dans un des moyens de stockage de l'appareil 100 avant d'être exécutés.

L'unité centrale 103 contrôle l'exécution des instructions ou portions de code logiciel du ou des programme(s) selon l'invention, instructions qui sont stockées dans le disque dur 112, dans la mémoire morte 104 ou dans les autres éléments de stockage précités. Lors de la mise sous tension, le ou les programmes stockés dans une mémoire non volatile, par exemple le disque dur 112 ou la mémoire morte 104, sont transférés dans la mémoire vive 106 (RAM), qui contient alors le code exécutable du ou des programme(s) selon l'invention, ainsi que des registres pour mémoriser les variables et les paramètres nécessaires à la mise en oeuvre de l'invention.

Il convient de noter que l'appareil comportant le dispositif selon l'invention peut également être un appareil programmé. Les instructions du ou des programme(s) mettant en oeuvre l'invention peuvent, par exemple, être implémentées dans un circuit intégré programmable ou spécifique (*Application-Specific Integrated Circuit*, ASIC).

Dans un logiciel de conception, les *templates*, ou modèles paramétriques liés à une géométrie 3D d'une pièce ou d'un ensemble de pièces, permettent à un utilisateur non spécialiste du logiciel de conception assistée par ordinateur de retrouver et de modifier facilement un paramètre en ne connaissant que le résultat qu'il souhaite atteindre. Ainsi, l'utilisation de modèles paramétriques permet d'obtenir une interface simplifiée pour modifier les paramètres sans modifier le code source. Cette interface simplifiée peut se présenter, par exemple, sous forme d'une fenêtre de dialogue permettant la visualisation et la modification de paramètres dans des champs prédéterminés. L'utilisation de ces modèles paramétriques permet aussi de programmer certaines contraintes sous formes de relations mathématiques. Les modèles paramétriques permettent également de présenter des résultats basés sur des relations mathématiques prédéterminées et sur des paramètres ou des données géométriques définis par l'utilisateur. Enfin, l'environnement associatif des modèles paramétriques autorise l'échange d'information permettant, par exemple, le positionnement des pièces 3D les unes par rapport aux autres, ainsi que l'accès à des informations utilisées pour calculer certaines caractéristiques des pièces 3D associées aux modèles paramétriques.

Les modèles paramétriques peuvent être associés à des éléments géométriques 3D. Il est ainsi possible d'extraire un modèle numérique du modèle paramétrique permettant une visualisation de l'élément ou d'une partie de l'élément auquel est associé le modèle paramétrique. La position de ces éléments peut être définie par rapport à d'autres éléments du même modèles paramétriques ou par rapport à des éléments d'un modèle paramétrique différent. Lorsqu'un élément est modifié ou déplacé, le logiciel de conception assistée par ordinateur modifie en conséquence les positions relatives de tous les éléments concernés, quelque soit le modèle paramétrique auquel ils appartiennent.

Le module d'aide au positionnement est basé sur l'utilisation de modèles paramétriques mémorisés dans un catalogue qui forme un ensemble totalement associatif. Chaque modèle paramétrique a un usage spécifique. Certains sont associés à des parties de l'avion, par exemple la nacelle et le moteur, d'autres représentent des entités fonctionnelles, par exemple le sol et la trajectoire de fragments de moteur en cas d'éclatement de celui-ci. Des modèles paramétriques différents d'un même objet 3D peuvent être utilisé selon le type d'étude à conduire.

Le positionnement d'un moteur sur un avion est un compromis entre plusieurs paramètres parmi lesquels:
- les interactions aérodynamiques entre le moteur et l'aile, entre le mât (jonction entre une aile et un ensemble propulsif constitué d'un nacelle et d'un moteur) et le moteur et entre le fuselage, les stabilisateurs et le moteur ;
- la masse du mât ainsi que les dimensions et la structure des renforcements de l'aile ou du fuselage ;
- la masse des trains d'atterrissage ;
- la dimension des stabilisateurs verticaux ;
- la perte de portance des ailes ;
- la conception des parties mobiles (volets, bords d'attaque, ailerons)
- le niveau de bruit généré par le moteur; et,
- l'impact d'un fragment de pâle sur la structure de l'avion et des systèmes vitaux.

Le système selon l'invention permet de prendre en compte ces contraintes sur tous les types d'avion pour le positionnement d'un ou de plusieurs moteurs. Selon un exemple de mise en oeuvre de ce système, le positionnement du moteur déterminé par l'utilisateur est automatiquement validé par rapport, notamment, aux données suivantes :
- la distance entre la nacelle et,
   ■ le sol (sol statique, sol lors d'un atterrissage par vent de travers et sol lors d'un atterrissage lorsque le train d'atterrissage avant est effacé) ;
   ■ la porte de cabine avant ; et,
   ■ le toboggan de la porte de cabine avant;
- la faisabilité, la taille et la forme de la nacelle ;
- la faisabilité, la taille et la forme du moteur ;
- la faisabilité, la taille et la forme de la structure du mât primaire (fixation de la nacelle et fixation du moteur) ;
- la faisabilité; la taille et la forme de la structure des mâts secondaires avant et arrière
- la masse des mâts (principal et secondaire) ;
- les coefficients aérodynamiques tels que la traînée résultant de l'installation du moteur sous l'aile ;
- la conséquence de l'éclatement du moteur sur la structure et les systèmes de l'avion ;
- le positionnement des mâts sur la nacelle, le moteur et l'aile ;
- l'ouverture de la nacelle pour les opérations de maintenance et l'inversion de poussée ;
- l'influence dû positionnement du moteur sur le bruit du moteur dans l'avion et au sol ;
- l'influence du positionnement du moteur sur les températures devant être supportées par certaines parties de l'avion ; et,
- l'influence des projections d'eau des trains d'atterrissage sur le positionnement du moteur.

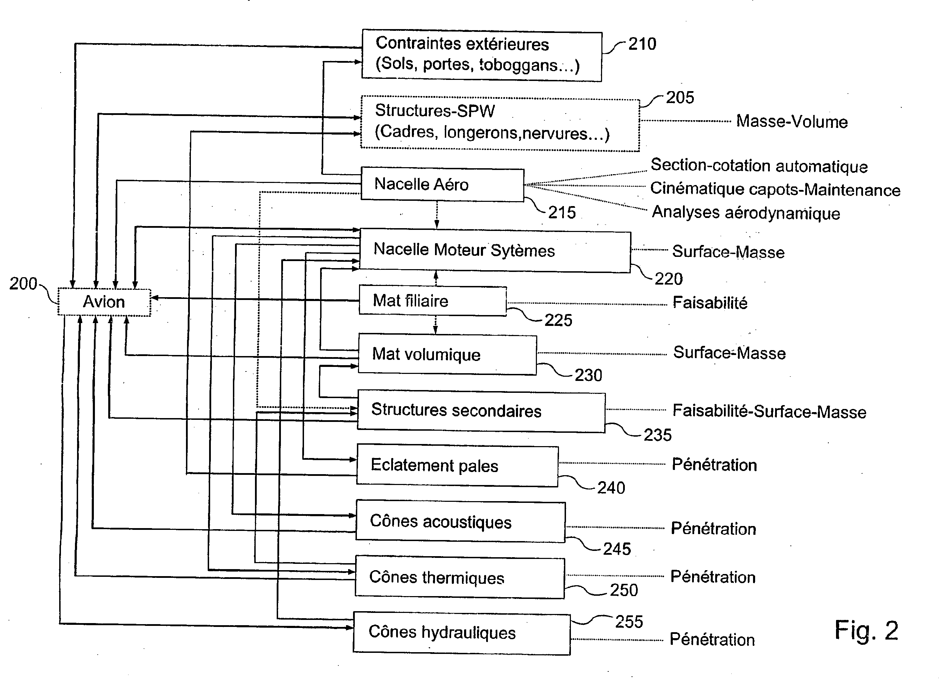

La figure 2 illustre schématiquement un exemple de l'environnement d'étude du positionnement d'un ensemble propulsif sur un avion, selon l'invention, ainsi que les relations entre cette étude et les corps de métier impliqués. Chaque rectangle représente un type d'analyse particulier. Les flèches indiquent une relation de causes à effets majeure. Les flèches pointillées correspondent à un transfert de données, entre modules, sous forme de texte. Les traits pointillés illustrent un exemple de données déterminées lors de l'analyse, pouvant être exportées de l'application, par exemple sous forme de fichier texte. Les rectangles représentés avec des traits pointillés représentent des modules externes utilisés pour l'étude.

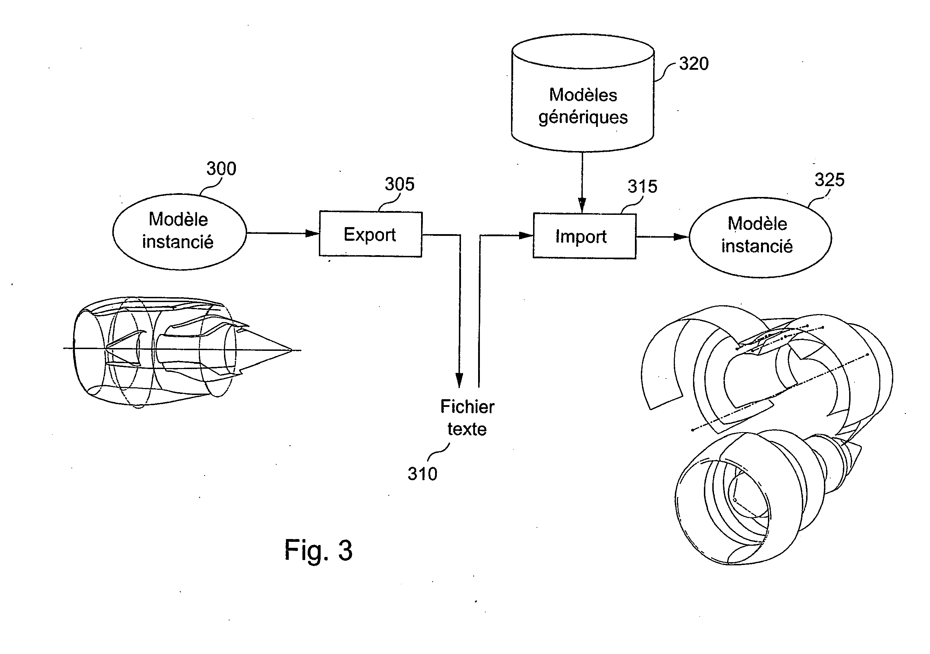

Chaque type d'analyse est, de préférence, associé à un modèle paramétrique particulier, certaines données de certains modèles paramétriques étant communes. Par exemple, les données relatives à une nacelle sont utilisées pour l'étude aérodynamique de la nacelle (215) et pour l'étude de l'ensemble propulsif composé d'une nacelle et d'un moteur. Comme décrit ultérieurement par référence à la figure 3, les données d'un modèle paramétrique peuvent être transmises à un autre modèle paramétrique en utilisant, par exemple, une fonction d'export et d'import de données, en mode texte, selon un ensemble de paramètres préalablement sélectionné.

Comme il l'a été mentionné le positionnement optimal d'un moteur sur un avion est lié à des contraintes géométriques et à des contraintes mathématiques. Par contraintes géométriques, il est fait référence aux contraintes qui peuvent être analysées visuellement pour déterminer si elles sont satisfaites ou non. Les contraintes mathématiques sont analysées par la comparaison de valeurs calculées avec des limites déterminées par un spécialiste.

Parmi les contraintes géométriques figure le lien entre l'avion et le sol, lié aux phases d'atterrissage et de décollage. Ces contraintes sont analysées par un ensemble de spécialistes et peuvent être regroupées dans un modèle paramétrique 210. Ce modèle interagit en particulier avec le modèle de l'avion et un modèle de la nacelle de telle sorte qu'un sol virtuel lié au caractéristique de l'avion soit présenté à l'utilisateur afin que celui-ci soit en mesure de déterminer le jeux existant entre le sol et la nacelle selon la position déterminée. De même, les limites liées à la position des portes et des toboggans peuvent être représentées par des plans permettant à l'utilisateur de déterminer la validité de la position de la nacelle selon le jeu existant entre ces plans et la nacelle.

Un autre ensemble de contraintes géométriques est lié aux problèmes aérodynamiques, tels que la traînée, engendrés par la position du moteur sous l'aile. Ces contraintes sont analysées par un autre ensemble de spécialistes et peuvent être regroupées dans un modèle paramétrique 215. Ce modèle paramétrique peut également comprendre d'autres contraintes, notamment des contraintes liées à la maintenance telles que l'ouverture des capots.

Les résultats de l'analyse peuvent être purement visuels comme l'affichage de sols virtuels et peuvent être analytiques comme l'affichage de coefficients aérodynamiques ou l'affichage de cotations et de sections. La représentation de surfaces isobares ainsi que la représentation de la nacelle capots ouverts et inverseurs de poussée activés permettent à l'utilisateur de contrôler visuellement la position de la nacelle selon ces contraintes. Les résultats analytiques peuvent être exportés, par exemple sous forme de texte, pour être exploités par un autre module du logiciel de conception assistée par ordinateur ou par une autre application, comme indiqué sur la figure 2. Une analyse des résultats analytiques permet une analyse plus fine qu'une analyse visuelle.

Une autre partie de l'analyse du positionnement de l'ensemble propulsif concerne la faisabilité de cet ensemble. Cette analyse peut être réalisée par l'utilisation d'un modèle paramétrique particulier (220) dont les données liées à la nacelle sont, de préférence, issues du modèle paramétrique de la nacelle 215. L'utilisateur peut contrôler visuellement la faisabilité d'un tel ensemble. Il peut également obtenir des résultats numériques tels que les masses et les surfaces. Ces résultats peuvent être exportés, par exemple sous forme de texte.

L'analyse du positionnement de l'ensemble propulsif peut également porter sur la liaison entre l'ensemble propulsif et l'aile de l'avion, c'est-à-dire sur le mât. Cette analyse est de préférence réalisée en deux phases distinctes. Une première phase est liée à la faisabilité. Cette phase utilise, de préférence, une représentation filaire du mât, plus facile à manipuler et pour laquelle un vrillage est plus facilement perceptible que sur une représentation surfacique qui de plus peut engendrer des problèmes au niveau du logiciel de conception assistée par ordinateur lorsque le mât n'est physiquement pas réalisable (bogues). La validité, déterminée par l'utilisateur selon l'analyse visuelle de la représentation filaire, peut être mémorisée dans le modèle paramétrique et peut ainsi être exportée pour être utilisée dans un autre modèle paramétrique ou dans une autre application. Lorsque l'utilisateur a constaté, de préférence visuellement, que le mât est réalisable, une étude surfacique ou volumique peut être conduite, dans une seconde phase, pour analyser d'autres types de données tels que les surfaces et les masses. Un modèle paramétrique différent est de préférence utilisé pour chacune de ces deux phases (225 et 230). Les données du modèle paramétrique lié à la représentation filaire du mât sont, de préférence, exportées vers le modèle paramétrique lié à la représentation volumique du mât. La représentation surfacique, ou volumique, du mât peut être affichée. Des résultats numériques tels que des masses et des surfaces sont de préférence automatiquement calculés dans le modèle paramétrique. Ces résultats peuvent être exportés.

L'analyse du mât peut se poursuivre par une analyse des structures secondaires concernant, en particulier, les éléments aérodynamiques couvrant au moins partiellement le mât et d'autres éléments externes au mât, utilisés entre un ensemble propulsif et une aile. Les éléments externes enveloppés par les structures secondaires comprennent notamment les liens électriques et les systèmes de transfert des fluides (air, carburant, etc.). Un modèle paramétrique est de préférence utilisé pour cette analyse à partir de laquelle l'utilisateur peut déterminer, par exemple, la faisabilité des structures secondaires, leur masse et leur surface. La représentation des structures secondaires, ou d'une partie des structures secondaires, peut être affichée. Des résultats numériques liés notamment à la faisabilité, aux masses et aux surfaces sont de préférence automatiquement calculés dans le modèle paramétrique. Comme précédemment, ces résultats peuvent être exportés.

Il est également nécessaire de contrôler la position du moteur selon les contraintes liées à la structure de l'avion et au risque d'éclatement des pales du moteur. Un modèle paramétrique 240 est de préférence dédié à cette analyse. Ce modèle paramétrique est lié à un modèle de la structure des parties vitales de l'avion (205) pouvant être un modèle paramétrique ou non de telle sorte que l'utilisateur puisse déterminer facilement le jeu entre la trajectoire d'un fragment de pale et les éléments vitaux de l'avion. Une représentation de la modélisation de la trajectoire d'un fragment de pale est de préférence affichée de telle sorte que l'utilisateur puisse, le cas échéant, localiser le point d'impact des fragments de pale sur la structure de l'avion ainsi que le degré de pénétration. Les informations liées au point d'impact et au degré de pénétration sont avantageusement déterminées automatiquement et peuvent être exportées sous forme de texte.

Il peut aussi être important d'étudier l'influence du positionnement du moteur sur le bruit perçu par les occupant de l'avion ainsi qu'au sol durant les phases de décollage et d'atterrissage. Un modèle paramétrique 245 comprenant une modélisation des émissions sonore, par exemple sous forme de cône acoustique peut être utilisé à cette fin. Un tel cône acoustique est de préférence affiché de telle sorte que l'utilisateur puisse, le cas échéant, localiser la partie de l'avion soumise à cette contrainte. Les informations liées aux parties de l'avion soumises à cette contrainte sont à nouveau avantageusement déterminées automatiquement et peuvent être exportées sous forme de texte.

De même, un modèle paramétrique 250 lié à l'influence de la position du moteur sur les températures devant être supportées par certaines parties de l'avion peut être utilisé. De façon également similaire, un autre modèle paramétrique 255 lié à l'influence des projections d'eau des trains d'atterrissage sur le positionnement du moteur peut aussi être utilisé. Comme les contraintes sonores, les contraintes thermiques et hydrauliques peuvent être représentées visuellement par des cônes. Les représentations des contraintes thermiques et hydrauliques sont de préférence affichées de telle sorte que l'utilisateur puisse, le cas échéant, localiser la partie de l'avion soumise à cette contrainte. Les informations liées aux parties de l'avion soumises à ces contraintes sont aussi avantageusement déterminées automatiquement et peuvent être exportées sous forme de texte.

Naturellement, d'autres contraintes peuvent être ajoutées au procédé d'aide au positionnement du moteur par la création de nouveaux modèles paramétriques ou par l'ajout de paramètres et/ou de relations mathématiques dans les modèles paramétriques existants. De même, le regroupement des contraintes par modèles paramétriques peut être différent. Par exemple, il est possible de regrouper les contraintes liées au bruit et au risque d'éclatement dans un même modèle paramétrique. Il est également possible de diviser le modèle paramétrique associé aux limites des portes et des toboggans en deux modèles paramétriques distincts.

L.'analyse du positionnement d'un ensemble propulsif est partiellement hiérarchique, certaines parties de l'analyse étant ordonnées, d'autres non. Par exemple, l'analyse des structures secondaires ne peut être réalisée qu'après avoir analysé le mât alors que les analyses des cônes acoustiques, thermiques et hydrauliques peuvent être effectuées dans un ordre quelconque ou de façon parallèle.

L'étude de toutes ces contraintes est traditionnellement réalisée par les experts des domaines techniques concernés, aidés si le besoin se présente par des experts en géométrie, en méthodologie ou en calcul. Cependant, l'utilisation de modèles paramétriques associatifs selon la méthode de l'invention permet à un utilisateur expérimenté d'établir une première analyse de l'ensemble de ces contraintes à partir d'une modélisation générique réalisée par des experts.

L'implémentation particulière du procédé selon l'invention pour positionner un moteur sur une aile d'avion utilise une trentaine de modèles paramétriques, représentant environ de 1,000 à 2,000 paramètres. Naturellement pour des raisons de clarté et de concision chaque modèle paramétrique n'est pas analysé en détail. De même, tous les paramètres d'un modèle paramétrique ne sont pas étudiés l'un après l'autre. La description présente le principe général du procédé selon l'invention en présentant des exemples de modèles paramétriques et des exemples de paramètres des modèles paramétriques.

Un modèle paramétrique de nacelle permet de définir, par exemple,
- la forme extérieure de la nacelle ;
- la forme de la tuyère ;
- le corps central de la tuyère ;
- les capots du moteur et leur axe de rotation ; et,
- les inverseurs de poussée et leur axe de rotation.

Ces données peuvent être mémorisées, par exemple, sous formes de points et de profils. Les profils sont, de préférence, définis par un ensemble de points et de tangentes en ces points permettant de les relier par des courbes. Chaque profil correspond à l'intersection d'une courbe représentant un élément de l'objet associé au modèle avec un plan prédéterminé.

Chaque modèle paramétrique comprend en outre, de préférence, un référentiel, permettant un positionnement d'un objet par rapport à un second. Par exemple, le référentiel d'une nacelle peut être un repère dont l'origine se situe sur l'axe de la nacelle, à une distance prédéterminée du point le plus en avant de la nacelle. L'axe des X peut être l'axe de la nacelle, l'axe des Y peut être l'axe perpendiculaire à l'axe des X, dans le plan horizontal, et l'axe des Z peut être l'axe perpendiculaire à l'axe des X, dans le plan vertical.

Ainsi, le profil d'une nacelle peut être défini selon un plan X-Y et selon un plan X-Z. Dans un mode préféré, deux profils sont déterminés dans le plan X-Z, un profil bas et un profil haut, les moteurs d'avion n'étant généralement pas symétriques selon le plan X-Y.

Comme indiqué précédemment, plusieurs modèles paramétriques d'un même objet 3D peuvent être créés. Par exemple, un modèle paramétrique peut être créé avec toutes les informations essentielles d'une nacelle tandis qu'un autre modèle paramétrique peut être créé avec toutes ces informations essentielles de la nacelle et comprenant en outre des formules de calcul de masses et de risques liés au positionnement.

Dans la suite de la description, un modèle générique est un modèle paramétrique dont les valeurs n'ont pas été initialisées ou ont été initialisées avec des valeurs par défaut. Les valeurs des paramètres d'un modèle générique peuvent donc être quelconques ou peuvent être prédéterminées de façon à être aussi proche que possible de modèles instanciés. Un modèle instancié est un modèle générique dont au moins certaines valeurs ont été initialisée. Un modèle instancié est un modèle «dynamique» permettant l'automatisation de certaines tâches ou de certains calculs et dont les paramètres peuvent être modifiés. Un modèle instancié est lié dynamiquement à d'autres modèles instanciés pour, par exemple, automatiser des calculs et mettre à jour des valeurs, notamment des valeurs de cotation. Un modèle générique peut donc être considéré comme le squelette d'un modèle instancié. Un modèle instancié peut être utilisé en tant que tel dans le logiciel de conception assistée par ordinateur. Les valeurs du modèle instancié peuvent également être utilisées pour créer d'autres modèles instanciés. Par exemple, les valeurs d'un modèle instancié de nacelle peuvent être utilisées pour instancier un modèle générique d'un ensemble propulsif dont les valeurs liées au moteur peuvent avoir été ou pourront être instanciées selon la même méthode.

Pour instancier un modèle générique à partir d'un modèle instancié, une solution consiste à exporter les données du modèle instancié sous forme de texte et à les importer dans le modèle générique devant être instancié. La figure 3 illustre ce mécanisme. Les données d'un modèle instancié (300) sont exportées (étape 305) sous forme de texte, par exemple sous forme de fichier texte (310). Les données exportées (310) sont ensuite importées (étape 315) dans un modèle générique sélectionné dans une base de données (320) comportant au moins un modèle générique pour former un nouveau modèle instancié (325). L'utilisateur peut, de préférence, choisir les paramètres ou les profils à exporter et à importer.

Plusieurs modèles instanciés d'un objet peuvent ainsi être créés à partir d'un ou de plusieurs modèles instanciés. Par exemple, un modèle instancié d'une nacelle comprenant une modélisation du comportement aérodynamique de la nacelle peut être créé à partir d'un simple modèle instancié de nacelle. De même, ce modèle instancié de nacelle comprenant une modélisation du comportement aérodynamique de la nacelle peut être utilisé pour créer un modèle instancié d'un ensemble propulsif comprenant la nacelle et un moteur.

L'utilisation des repères des modèles paramétriques, par exemple de la nacelle et du moteur, ainsi que des paramètres contenus dans ces modèles permet de positionner les objets représentés par ces modèles lorsque les modèles génériques correspondants sont instanciés, c'est-à-dire lorsque des valeurs sont données aux paramètres permettant ce positionnement. De plus, le lien entre les modèles instanciés est dynamique de sorte que si un paramètre de positionnement d'un objet est modifié, les autres modèles sont dynamiquement adaptés.

En utilisant cette solution, il est possible de fractionner l'étude du positionnement d'un ensemble propulsif tout en associant les données intermédiaires de telle sorte que l'étude soit validée dans son ensemble.

Après avoir lancé le logiciel de conception assistée par ordinateur, l'utilisateur doit, de préférence, sélectionner un modèle instancié d'un premier objet par rapport auquel un second objet doit être positionné. Dans cet exemple, le premier objet est une structure d'avion ou d'une partie de la structure d'un avion, comportant des ailes, ayant un repère prédéterminé permettant l'ajout d'éléments à des positions précises. Le repère généralement utilisé consiste à prendre le nez de l'avion comme origine, l'axe du fuselage comme axe des X, la perpendiculaire à l'axe des X, dans le plan des ailes, comme axe des Y, et la normal au plan formé par les axes des X et des Y comme axe des Z. Un modèle numérique de ce premier objet, ou d'une partie de ce premier objet, est affiché.

Si l'utilisateur souhaite déterminer une position initiale de la nacelle selon les limites des portes et des toboggans, une instance du modèle paramétrique lié aux ouvertures et au sol est alors créée selon les données du modèle instancié de l'avion ou de la partie d'avion. Ce modèle lié aux ouvertures et au sol permet de déterminer et d'afficher les surfaces limites pour le sol, les portes de cabine avant et les toboggans. Le positionnement des éléments associés à ce modèle est automatiquement réalisé durant l'instanciation, selon des références mémorisées dans le modèle, par exemple selon les plans X-Y, Y-Z et Z-X du fuselage et la tangente au nez du fuselage en fonction du repère lié à la structure de l'avion. Chaque surface est de préférence visualisée avec une couleur différente. Par exemple, le vert clair peut représenter le sol statique, le bleu peut représenter le sol lors de l'atterrissage par vent de travers, le jaune peut représenter le sol lors de l'atterrissage avec le train d'atterrissage avant effacé, le vert foncé peut représenter les limites des toboggans et le rouge peut représenter les limites des portes de cabine avant. En utilisant l'éditeur de paramètres du modèle paramétrique, l'utilisateur peut définir les dimensions réelles de ces éléments et les limites associées. Par exemple, pour chaque plan représentant le sol (statique, atterrissage par vent de travers ou avec le train d'atterrissage avant effacé), l'utilisateur peut entrer les distances entre le point d'atterrissage avant et les plans X-Y, Y-Z et Z-X, les distances entre le point d'atterrissage principal et les plans X-Y, Y-Z et Z-X, l'angle de roulis et l'angle de tangage de l'avion. Après avoir entré ou modifié ces valeurs, certaines variables sont calculées pour aider l'utilisateur. En particulier, l'angle entre le plan X-Y et le sol statique, la distance entre les points d'atterrissage et la distance entre les points d'atterrissage selon l'axe X. De même, en ce qui concerne les portes et le toboggans, l'utilisateur peut entrer ou modifier la distance entre le plan Y-Z et le milieu de la porte, la distance minimum entre le milieu de la porte et le plan d'extrémité avant du moteur, l'angle relatif entre le toboggan et le plan Y-Z selon l'axe de rotation du toboggan, la largeur du toboggan et la distance selon l'axe Y entre l'axe de rotation du toboggan et le plan Z-X. Les plans représentant les limites des portes, des toboggans et du sol peuvent être affichés ou masqués à tout instant pour permettre à l'utilisateur de cibler son analyse.

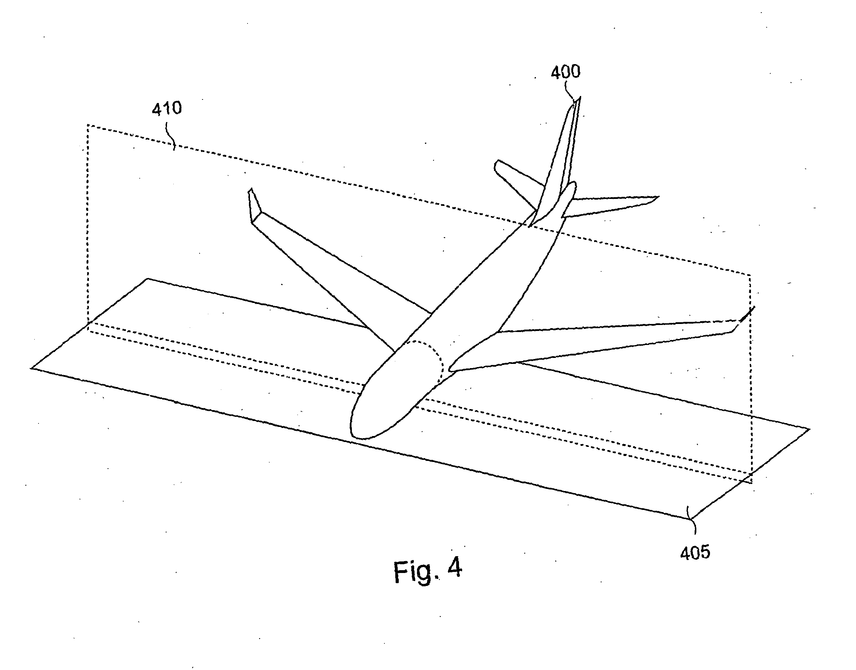

La figure 4 illustre un avion 400, le repère géométrique utilisé ainsi que les limites liées au sol par atterrissage avec le train d'atterrissage avant effacé 405 et à l'ouverture des portes 410. La figure 4 permet à un utilisateur de déterminer a priori les zones possibles de positionnement d'une nacelle ou d'un ensemble propulsif selon les contraintes affichées. Lorsqu'une nacelle ou un ensemble propulsif est positionné sur l'aile de l'avion à partir des paramètres et des références mémorisées dans les modèles instanciés de l'avion et de la nacelle une représentation équivalente à celle de la figure 4, ou une vue plus précise telle qu'une coupe selon un plan X-Z permet de déterminer le jeux entre les contraintes extérieures matérialisées par des plans ou des droites et les extrémités de la nacelle ou de l'ensemble propulsif.

Après avoir affiché le premier objet et, éventuellement, une représentation d'un premier ensemble de contraintes, l'utilisateur peut sélectionner un modèle instancié du second objet, c'est-à-dire la nacelle dans cette exemple. Une position initiale de cet objet est de préférence déterminée automatiquement selon certaines données du premier objet et éventuellement selon des contraintes préalablement étudiées. La détermination de cette position initiale, avantageusement valide, peut être réalisée à partir des caractéristiques du premier objet et de l'emplacement approximatif du second objet, modifié selon les éventuelles contraintes préalablement étudiées. Dans l'exemple décrit, la position initiale de la nacelle est automatiquement déterminée selon la structure de l'avion, et en particulier de l'aile, et selon, notamment, les contraintes liées au sol, aux portes et aux toboggans. Cette position initiale peut être modifiée par l'utilisateur selon, par exemple, ses coordonnées, relatives ou absolues Après avoir déterminé la position initiale de la nacelle, un modèle numérique de celle-ci, ou un modèle numérique d'une partie de celle-ci, est affiché.

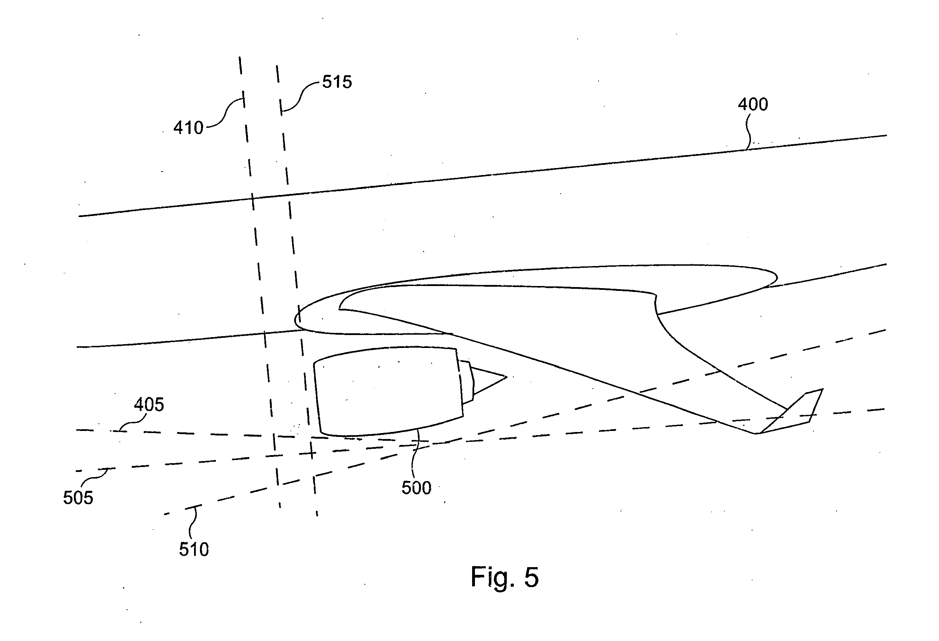

La figure 5 illustre une vue de côté d'un avion sur une aile duquel une nacelle a été positionnée. Comme illustré sur cette figure, l'extrémité avant de la nacelle 500 est située à une certaine distance des plans de limites des toboggans 410 et de limite de porte 515. Le positionnement de la nacelle peut donc être considéré comme valide par rapport à ces deux contraintes. Il en est de même avec les plans de sol représentés par les lignes 405, 505 et 510 représentant respectivement le sol lors de l'atterrissage avec le train d'atterrissage avant effacé, le sol statique et le sol lors de l'atterrissage par vent de travers.

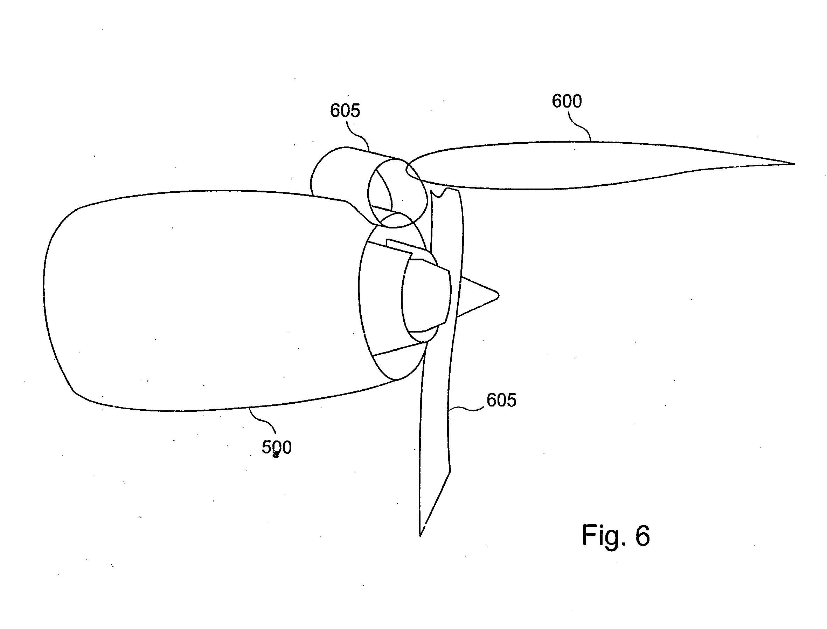

En utilisant un modèle instancié de nacelle et un modèle instancié d'avion ou de voilure comprenant une modélisation de contraintes aérodynamiques, l'utilisateur peut également contrôler l'aérodynamisme lié à la position de la nacelle par rapport à la voilure. Cette analyse peut se faire en comparant la position des surfaces isobares liées à la voilure avec celle de la nacelle. La figure 6 illustre des surfaces théoriques 605 de limite de surpressions aérodynamiques liées à la voilure 600. L'analyse visuelle montre que ces limites de surpressions entrent en contact avec la nacelle 500. Selon la nature de ces surfaces isobares et la finesse de l'analyse, la position de la nacelle peut être considérée comme valide ou non. Si la position de la nacelle est considérée comme valide, il peut être nécessaire de calculer une pénalité liée au degré de pénétration de la courbe isobare dans la nacelle. Ce calcul est de préférence intégré dans le modèle instancié de la nacelle. Il peut également être intégré dans un autre modèle paramétrique tel que le modèle instancié de l'avion ou de la voilure. Si la position de la nacelle n'est pas considérée comme valide, la position de la nacelle peut être modifiée. La modification de cette position peut, comme précédemment, être effectuée à l'aide des coordonnées de la nacelle. Les contraintes analysées sont alors ré-évaluées et leur représentation est mise à jour.

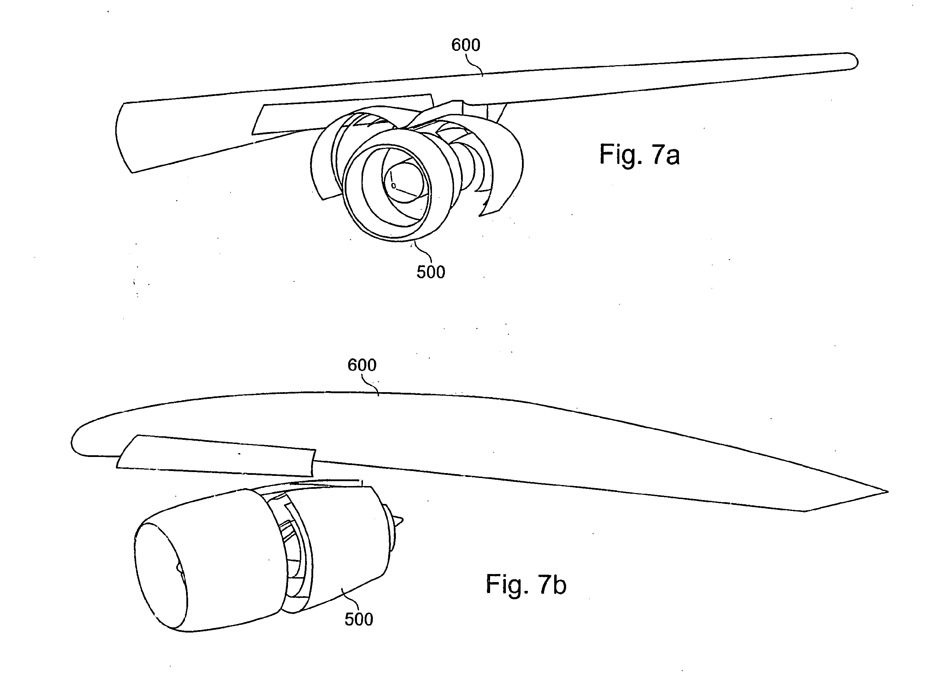

De même, les modèles instanciés de l'avion et de la nacelle peuvent être utilisés pour valider la position de la nacelle selon les contraintes liées à l'inversion de la poussée et selon les contraintes liées à l'ouverture des capots du moteur pour sa maintenance comme illustré sur les figures 7a et 7b, respectivement.

Il convient de noter que l'analyse précédente effectuée selon les contraintes géométriques est basée sur la nacelle seule cependant, l'étude être réalisée avec l'ensemble nacelle et moteur.

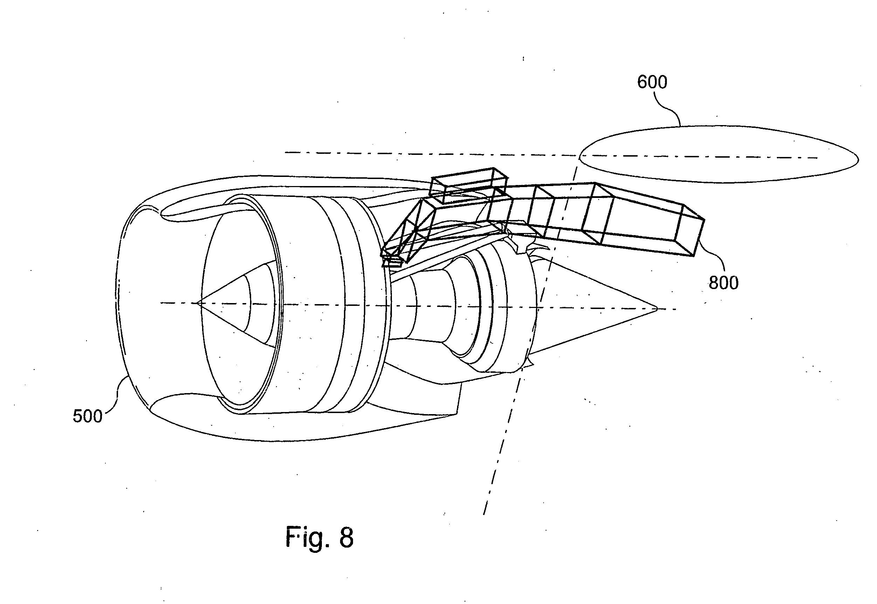

Après avoir déterminé et validé une position initiale de la nacelle par rapport à l'aile de l'avion, il est possible d'analyser les caractéristiques du mât c'est-à-dire de la jonction entre l'ensemble propulsif et l'aile. Pour cette analyse, un modèle paramétrique distinct est de préférence utilisé. Un modèle générique d'ensemble propulsif comprenant une modélisation du mât est instancié avec les paramètres de la nacelle utilisés dans l'étude précédente ainsi qu'avec les paramètres d'un moteur sélectionné par l'utilisateur. Ces paramètres comprennent en particulier les paramètres liés à la nacelle en elle-même ainsi que les paramètres liés à son positionnement relativement à l'aile. Lorsque ce modèle d'ensemble propulsif est instancié, les caractéristiques du mât sont automatiquement déterminées selon les positions de l'ensemble propulsif et de l'aile. Un mât filaire 800 est de préférence affiché, comme représenté sur la figure 8, permettant à l'utilisateur de déterminer si le mât est réalisable ou non.

Si le mât n'est pas réalisable, c'est-à-dire si la position de la nacelle ne permet pas la réalisation du mât, la position de la nacelle est de préférence modifiée même si par ailleurs la position de la nacelle est valide par rapport à d'autres contraintes. A nouveau, toutes les contraintes analysées précédemment sont ré-évaluées et leur représentation est mise à jour.

Si le mât est réalisable, un modèle surfacique de mât peut être utilisé pour poursuivre l'étude en analysant, en particulier, la masse et les surfaces de ce mât. Cette étude complémentaire peut être réalisée à partir du même modèle instancié d'ensemble propulsif ou à partir d'un modèle générique, instancié avec les données du modèle instancié utilisé pour l'étude filaire du mât.

De même, le modèle instancié de l'ensemble propulsif comprenant une modélisation filaire ou surfacique du mât peut être utilisé pour analyser les structures secondaires. Cependant, il est préférable d'utiliser un modèle distinct. Les données du modèle instancié de l'ensemble propulsif comprenant une modélisation surfacique du mât peuvent être utilisé pour instancier un modèle générique d'ensemble propulsif comprenant une modélisation des structures secondaires selon la méthode présentée précédemment.

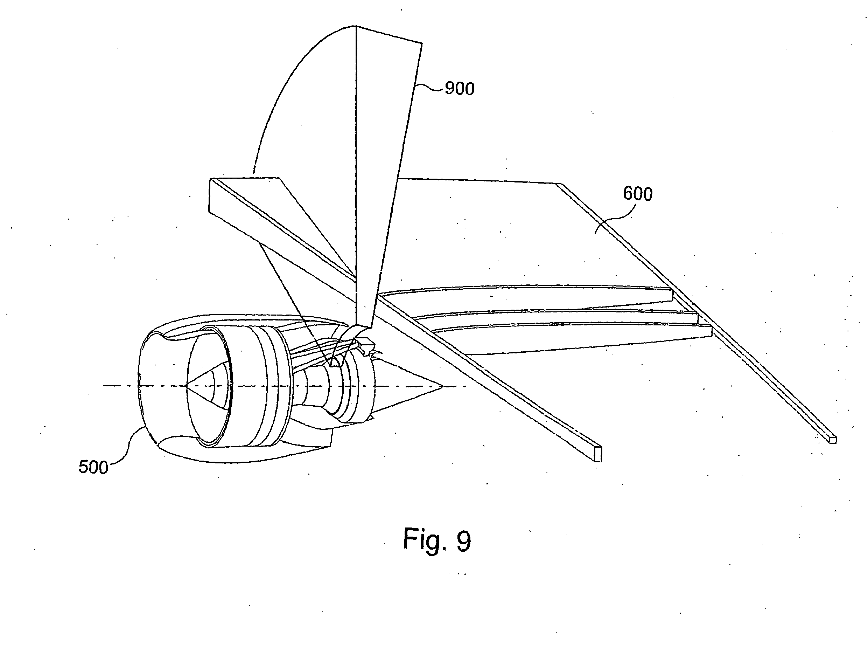

Après cette étude, simultanément ou avant, il est possible d'analyser les contraintes liées au risque d'éclatement du moteur. Selon ces contraintes, il doit être vérifié, en particulier, que les fragments de pales ne peuvent pas endommager un élément vital de l'avion. Pour cela, un modèle instancié du moteur comprenant une modélisation des trajectoires des fragments de pales peut être utilisé. Ces trajectoires peuvent être représentées, par exemple, sous forme de cônes. Comme précédemment, un modèle générique est instancié à partir des données utilisées dans les études précédentes. La figure 9 illustre un cône 900 d'éclatement de pales de la turbine de telle sorte qu'il est possible de déterminer, selon la structure de l'aile 600 et de l'avion (non représenté), si les parties vitales de l'avion seraient atteintes par un fragment de pale.

De la même façon, il est possible d'analyser l'influence du positionnement du moteur sur le bruit du moteur dans l'avion et au sol, sur les températures devant être supportées par certaines parties de l'avion et l'influence des projections d'eau des trains d'atterrissage sur le positionnement du moteur. Ces analyses sont de préférence effectuées à l'aide de modèles paramétriques différents, chaque modèle comprenant une modélisation géométrique de la contrainte étudiée. Par exemple, plusieurs cônes sonores peuvent être utilisés : un cône sonore devant l'entrée de la chambre de compression du moteur, un cône sonore derrière la chambre de compression du moteur, un cône sonore derrière la chambre de combustion et un cône sonore derrière la sortie des gaz. Chaque cône sonore peut être défini dans le modèle paramétrique correspondant avec comme paramètres une forme, une dimension et une position. Le positionnement des cônes sonores est réalisé automatiquement lors de l'instanciation du modèle générique du moteur comprenant cette modélisation.

Comme décrit précédemment, le système selon l'invention est basé sur l'utilisation d'un ensemble de modèles paramétriques associatifs permettant d'établir un lien entre chaque type d'analyse. Ainsi, lorsqu'un paramètre tel que la position en Y de l'ensemble propulsif est modifié, cette modification est prise en compte dans tous les modèles paramétriques de telle sorte que l'utilisateur peut rapidement validé ou non cette modification selon un ensemble de contraintes par une simple visualisation de l'influence de cette modification sur les limites affichées et sur les résultats obtenus notamment ceux liés aux masses et aux surfaces. Par exemple, si l'ensemble propulsif est avancé de quelques dizaines de centimètres, l'utilisateur peut visualiser rapidement si les jeux par rapport aux plans de limites des toboggans et aux sols sont respectés, si le mât est faisable, s'il n'est pas trop lourd et ainsi de suite pour toutes les contraintes. Cette gestion dynamique permet de déterminer rapidement une position satisfaisant l'ensemble des contraintes même si chacune des contraintes doit ensuite être validée par une analyse plus approfondie.

L'utilisateur est avantageusement libre d'afficher ou de masquer certaines vues ou certaines contraintes matérialisées par des plans, des courbes, des cônes ou toute autre représentation. De la même façon, il peut afficher ou masquer les résultats analytiques tels que les masses et les surfaces.

Il est également possible d'ajouter de nouvelles contraintes à une étude en utilisant simplement un nouveau modèle paramétrique lié à cette nouvelle contrainte tout en utilisant l'ensemble de l'étude préalablement réalisée. Il est également possible de comparer plusieurs positions d'ensembles propulsifs en instanciant plusieurs modèles similaires avec des données différentes.

L'étude du positionnement de l'ensemble propulsif sur une aile d'avion est donc un processus itératif selon lequel les contraintes sont étudiées les unes après les autres ou simultanément selon la nature de ces contraintes et selon lequel la modification des paramètres de positionnement entraîne une mise à jour automatique de l'évaluation des contraintes et de leur représentation.

Selon la nature et la complexité des objets à positionner et des contraintes analysées, la modélisation des contraintes peut être intégrée dans le modèle paramétrique d'un objet, ici la voilure, la nacelle ou le moteur, ou dans un modèle paramétrique indépendant. Si la modélisation de certaines contraintes est intégrée dans un ou plusieurs modèles paramétriques indépendants, ces modèles paramétriques indépendants peuvent comprendre une partie des données des modèles instanciés des objets.

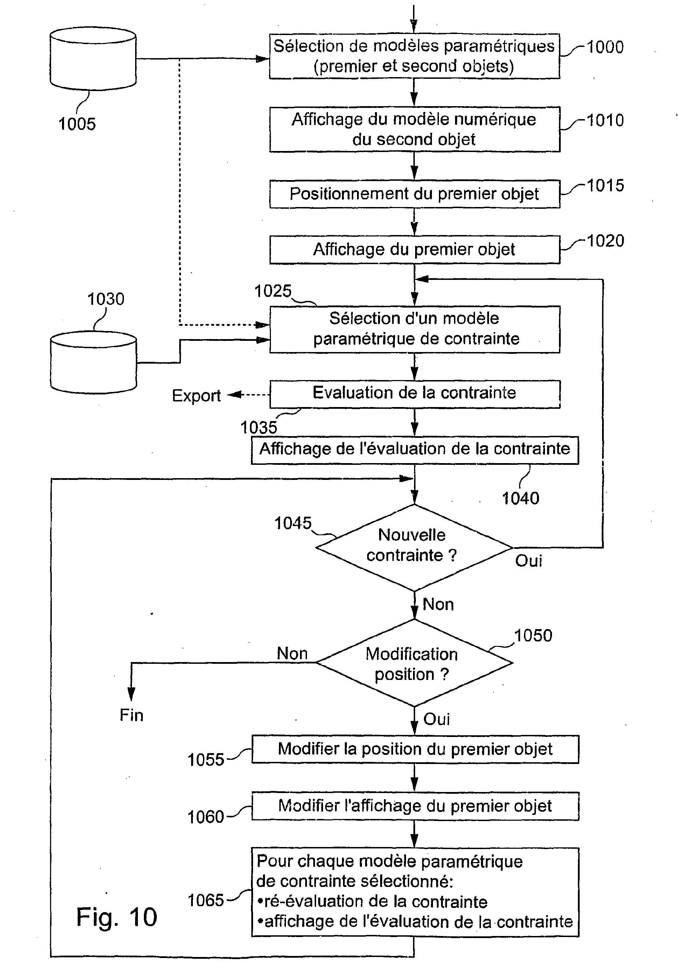

La figure 10 illustre schématiquement certaines étapes d'un exemple de mise en oeuvre de l'invention à l'aide d'un logiciel de conception assistée par ordinateur et d'un appareil tel que celui décrit par référence à la figure 1. Le procédé illustré sur la figure 10 permet de positionner un premier objet par rapport à un second, par exemple un ensemble propulsif par rapport à une aile d'avion selon, notamment, les contraintes évoquées précédemment.

Après avoir sélectionné des modèles paramétriques instanciés des premier et second objets (étape 1000), par exemple dans une bibliothèque (1005), une représentation numérique du second objet est affichée (étape 1010). La position initiale du premier objet est déterminée (étape 1015). La position initiale du premier objet relativement au second objet peut être déterminée par l'utilisateur ou, de préférence, est déterminée automatiquement selon certaines données du modèle paramétrique instancié du second objet. Une représentation numérique du premier objet est affichée (étape 1020).

Un modèle paramétrique comprenant une modélisation d'une contrainte liée à la position du premier objet relativement au second est sélectionné (étape 1025), par exemple dans la bibliothèque 1030. Une partie des données d'un ou des modèles paramétriques des premier et second objet peut être recopiée dans le modèle paramétrique sélectionné comprenant une modélisation d'une contrainte, comme suggéré par le trait pointillé reliant la bibliothèque 1005 à l'étape 1025. De même, une partie des données d'un ou de plusieurs modèles paramétriques comprenant une modélisation de contraintes préalablement étudiées peut être recopiée dans le modèle paramétrique sélectionné comprenant une modélisation d'une contrainte. Alternativement, la modélisation de la contrainte mentionnée peut appartenir à l'un des modèles paramétriques des premier et second objets. Il n'est donc pas nécessaire dans ce dernier cas de sélectionner un autre modèle paramétrique comprenant une modélisation de la contrainte mentionnée.

La contrainte mentionnée est évaluée à l'aide de sa modélisation et de la position du premier et/ou de second objet (étape 1035). Alternativement, la contrainte mentionnée peut être évaluée à l'aide de sa modélisation et de la position relative des premier et second objets. Le résultat de l'évaluation de la contrainte est de préférence un ensemble de valeurs numériques ou de formes numériques, c'est-à-dire un ensemble composé de points, de courbes, de surfaces et/ou de volumes. Si le résultat de l'évaluation de la contrainte mentionnée consiste en des valeurs numériques, celles-ci sont de préférence mémorisées dans le modèle paramétrique comprenant la modélisation de la contrainte mentionnée. Ces valeurs numériques peuvent être affichées et/ou exportées (comme suggéré par la flèche en pointillé) pour être utilisées par une autre application. Si le résultat de la contrainte est une forme numérique, ou un ensemble de formes numériques, ces formes sont de préférence affichées (étape 1040). L'affichage de ces formes permet à l'utilisateur de valider visuellement, ou non, la position du premier objet par rapport au second selon la contrainte évaluée.

Un test est ensuite effectué pour déterminer si l'utilisateur souhaite valider la position du premier objet par rapport au second selon une autre contrainte (étape 1045). Si l'utilisateur souhaite valider la position du premier objet par rapport au second selon une autre contrainte, les trois précédentes étapes (étapes 1025 à 1040) sont répétées. Sinon, un second test est effectué pour déterminer si l'utilisateur souhaite modifier la position du premier objet par rapport au second (étape 1050). Si l'utilisateur souhaite modifier la position du premier objet par rapport au second, il détermine la nouvelle position du premier objet (étape 1055). Comme précédemment, la position du premier objet relativement au deuxième objet peut être déterminée par ses coordonnées ou peut être déterminée en sélectionnant un ou plusieurs points du second objet à l'aide, par exemple, d'une souris. L'affichage du premier objet est ensuite modifié selon sa nouvelle position (étape 1060).

Lorsque la position du premier objet est modifiée, chaque contrainte est ré-évaiuée selon la modélisation de la contrainte et la nouvelle position du premier objet (étape 1065). L'affichage du résultat de l'évaluation de chaque contrainte est modifié selon les résultats de ré-évaluation.

L'utilisateur peut alors à nouveau évaluer de nouvelles contraintes (étape 1045) ou modifier la position du premier objet (étape 1050).

Naturellement, pour satisfaire des besoins spécifiques, une personne compétente dans le domaine de l'invention pourra appliquer des modifications dans la description précédente.

## Revendications

1. Procédé informatisé d'aide au positionnement d'un premier objet relativement à un second objet selon au moins une contrainte liée à la position relative desdits premier et second objets, le procédé étant **caractérisé en ce que** ledit premier objet comprenant au moins une partie d'un ensemble propulsif pour aéronef et ladite au moins une contrainte étant liée à l'aérodynamique d'au moins une partie dudit premier objet, aux pièces mobiles d'au moins une partie dudit premier objet, au risque d'éclatement d'au moins une partie dudit premier objet ou au bruit ou à la chaleur pouvant être émis par au moins une partie dudit premier objet, le procédé comprend les étapes suivantes,
- sélection d'un modèle paramétrique associé à chacun desdits premier et second objets (1000) ;
- affichage d'un modèle numérique dudit second objet selon ledit modèle paramétrique associé audit second objet (1010) ;
- positionnement dudit premier objet relativement audit second objet selon des paramètres desdits modèles paramétriques associés auxdits premier et second objets (1015) ;
- affichage d'un modèle numérique (500) dudit premier objet selon ledit modèle paramétrique associé audit premier objet et selon ledit positionnement (1020) ;
- sélection d'au moins un modèle paramétrique comprenant une modélisation de ladite au moins une contrainte (1025) ;
- pour ledit au moins un modèle paramétrique comprenant une modélisation de ladite au moins une contrainte,
■ acquisition d'au moins une donnée liée à la position d'au moins l'un desdits premier et second objets ;
■ évaluation de ladite au moins une contrainte selon ladite au moins une donnée (1035).

2. Procédé selon la revendication 1 **caractérisé en ce que** le procédé comprend en outre une étape de modification d'au moins un paramètre d'au moins un desdits modèles paramétriques associés auxdits premier et second objets (1050), lesdites étapes de,
■ acquisition d'au moins une donnée liée à la position d'au moins l'un desdits premier et second objets ; et,
■ évaluation de ladite au moins une contrainte selon ladite au moins une donnée,
étant ré-exécutées (1065) pour ledit au moins un modèle paramétrique comprenant une modélisation de ladite au moins une contrainte, après ladite modification dudit au moins un paramètre.

3. Procédé selon la revendication 1 ou la revendication 2 **caractérisé en ce que** le procédé comprend en outre une étape d'affichage du résultat de ladite évaluation de ladite au moins une contrainte.

4. Procédé selon la revendication 3 **caractérisé en ce que** ladite étape d'affichage comprend une étape d'affichage d'une indication graphique associée à ladite au moins une contrainte de telle sorte qu'une analyse visuelle de la position de ladite indication graphique relativement à au moins l'un des modèles numériques associés auxdits premier et second objets permette de valider la position dudit premier objet selon ladite au moins une contrainte (1040).

5. Procédé selon la revendication 3 ou la revendication 4 **caractérisé en ce que** ladite étape d'affichage du résultat de ladite évaluation de ladite au moins une contrainte comprend une étape d'affichage d'une moins une valeur, ladite valeur permettant de valider la position dudit premier objet selon ladite au moins une contrainte.

6. Procédé selon l'une quelconque des revendications précédentes **caractérisé en ce que** ledit au moins un modèle paramétrique comprenant une modélisation de ladite au moins une contrainte est compris dans l'un desdits modèles paramétriques associés auxdits premier et second objets.

7. Procédé selon l'une quelconque des revendications 1 à 5 **caractérisé en ce qu'**au moins une donnée dudit au moins un modèle paramétrique comprenant une modélisation de ladite au moins une contrainte est importée (315) de l'un desdits modèles paramétriques associés auxdits premier et second objets.

8. Procédé selon l'une quelconque des revendications précédentes **caractérisé en ce que** ledit second objet comprend au moins une partie d'un aéronef.

9. Procédé selon la revendication 8 **caractérisé en que** ladite au moins une contrainte est liée à au moins l'une des positions suivantes : position des portes, position des toboggans, position du sol, position relative du sol lors d'un atterrissage par vent de travers et position relative du sol lors d'un atterrissage avec le train d'atterrissage avant effacé.

10. Dispositif comprenant des moyens adaptés à la mise en oeuvre de chacune des étapes du procédé selon l'une quelconque des revendications 1 à 9.

11. Programme d'ordinateur comprenant des instructions adaptées à la mise en oeuvre de chacune des étapes du procédé selon l'une quelconque des revendications 1 à 9.

## Claims

1. A computerized method for aiding in the positioning of a first object relative to a second object according to at least one constraint linked with the relative position of the said first and second objects, the method being **characterized in that**, said first object comprising at least part of a propulsive assembly for an aircraft and said at least one constraint being linked to the aerodynamics of at least part of said first object, to the movable components of at least part of said first object, to the risk of bursting of at least part of said first object or to the noise or to the heat that can be emitted by at least part of said object, the method comprises the following steps,
- selecting (1000) a parametric model associated with each of the said first and second objects;
- displaying (1010) a numerical model of the said second object according to the said parametric model associated with the said second object;
- positioning (1015) the said first object relative to the said second object according to the parameters of the said parametric models associated with the said first and second objects;
- displaying (1020) a numerical model (500) of the said first object according to the said parametric model associated with the said first object and according to the said positioning;
- selecting (1025) at least one parametric model comprising modeling of the said at least one constraint;
- for the said at least one parametric model comprising modeling of the said at least one constraint,
• acquiring at least one item of data linked with the position of at least one of the said first and second objects;
• evaluating (1035) the said at least one constraint according to the said at least one item of data.

2. A method according to claim 1, **characterized in that** the method additionally comprises a step (1050) of modifying at least one parameter of at least one of the said parametric models associated with the said first and second objects, the said steps of
• acquiring at least one item of data linked with the position of at least one of the said first and second objects; and
• evaluating the said at least one constraint according to the said at least one item of data,
being repeated (1065), after the said modification of the said at least one parameter, for the said at least one parametric model comprising modeling the said at least one constraint.

3. A method according to claim 1 or claim 2, **characterized in that** the method additionally comprises a step of displaying the result of the said evaluation of the said at least one constraint.

4. A method according to claim 3, **characterized in that** the said display step comprises a step of displaying (1040) a graphical indication associated with the said at least one constraint in such a way that a visual analysis of the position of the said graphical indication relative to at least one of the numerical models associated with the said first and second objects makes it possible to validate the position of the said first object according to the said at least one constraint.

5. A method according to claim 3 or claim 4, **characterized in that** the said step of displaying the result of the said evaluation of the said at least one constraint comprises a step of displaying at least one value, the said value making it possible to validate the position of the said first object according to the said at least one constraint.

6. A method according to any one of the preceding claims, **characterized in that** the said at least one parametric model comprising modeling of the said at least one constraint is included in one of the said parametric models associated with the said first and second objects.

7. A method according to any one of claims 1 to 5, **characterized in that** at least one item of data of the said at least one parametric model comprising modeling of the said at least one constraint is imported (315) from one of the said parametric models associated with the said first and second objects.

8. A method according to any one of the preceding claims, **characterized in that** the said second object comprises at least part of an aircraft.

9. A method according to claim 8, **characterized in that** the said at least one constraint is linked with at least one of the following positions: position of doors, position of evacuation slides, position of the ground, relative position of the ground during landing in a crosswind and relative position of the ground during landing with the front landing gear retracted.

10. A device comprising means adapted for the implementation of each of the steps of the method according to any one of claims 1 to 9.

11. A computer program comprising instructions adapted for the implementation of each of the steps of the method according to any one of claims 1 to 9.

## Patentansprüche

1. Rechnergestütztes Verfahren zur Hilfe bei der Positionierung eines ersten Objekts in Bezug auf ein zweites Objekt gemäß zumindest einer Zwangsbedingung, die mit der relativen Position des ersten und des zweiten Objekts in Zusammenhang steht, wobei das Verfahren **dadurch gekennzeichnet ist,**
**dass** das erste Objekt zumindest einen Abschnitt eines Triebwerksaggregats für ein Luftfahrzeug umfasst und die zumindest eine Zwangsbedingung mit der Aerodynamik zumindest eines Abschnitts des ersten Objekts, mit den beweglichen Teilen zumindest eines Abschnitts des ersten Objekts, mit der Berstgefahr zumindest eines Abschnitts des ersten Objekts oder mit dem Lärm oder der Wärme in Zusammenhang steht, die von zumindest einem Abschnitt des ersten Objekts erzeugt werden kann, wobei das Verfahren die folgenden Schritte umfasst:
- Wählen eines parametrischen Modells, das mit einem jeden von dem ersten und zweiten Objekt verknüpft ist (1000);
- Anzeigen eines digitalen Modells des zweiten Objekts gemäß dem mit dem zweiten Objekt verknüpften parametrischen Modell (1010);
- Positionieren des ersten Objekts in Bezug auf das zweite Objekt gemäß Parametern der mit dem ersten und dem zweiten Objekt verknüpften parametrischen Modelle (1015);
- Anzeigen eines digitalen Modells (500) des ersten Objekts gemäß dem mit dem ersten Objekt verknüpften parametrischen Modell und gemäß der Positionierung (1020);
- Wählen zumindest eines parametrischen Modells, das eine Modellierung der zumindest einen Zwangsbedingung umfasst (1025);
- für das zumindest eine parametrische Modell, das eine Modellierung der zumindest einen Zwangsbedingung umfasst,
* Erfassen zumindest eines mit der Position des ersten und/oder des zweiten Objekts in Zusammenhang stehenden Datenelements;
* Bewerten der zumindest einen Zwangsbedingung gemäß dem zumindest einen Datenelement (1035).

2. Verfahren nach Anspruch 1,
**dadurch gekennzeichnet, dass**
das Verfahren ferner einen Schritt zur Änderung zumindest eines Parameters zumindest eines der parametrischen Modelle umfasst, die mit dem ersten und dem zweiten Objekt verknüpft sind (1050), wobei nach der Änderung des zumindest einen Parameters (1065) für das zumindest eine parametrische Modell, das eine Modellierung der zumindest einen Zwangsbedingung umfasst, erneut die Schritte ausgeführt werden, dass:
* Erfassen zumindest eines mit der Position des ersten und/oder des zweiten Objekts in Zusammenhang stehenden Datenelements; und
* Beurteilen der zumindest einen Zwangsbedingung gemäß dem zumindest einen Datenelement.

3. Verfahren nach Anspruch 1 oder 2,
**dadurch gekennzeichnet, dass**
das Verfahren ferner einen Schritt zur Anzeige des Ergebnisses der Bewertung der zumindest einen Zwangsbedingung umfasst.

4. Verfahren nach Anspruch 3,
**dadurch gekennzeichnet, dass**
der Schritt zur Anzeige einen derartigen Schritt zur Anzeige einer mit der zumindest einen Zwangsbedingung verknüpften graphischen Angabe umfasst, dass eine visuelle Analyse der Position der graphischen Angabe in Bezug auf zumindest das eine der digitalen Modelle, die mit dem ersten und dem zweiten Objekt verknüpft sind, das Bestätigen der Position des ersten Objekts gemäß der zumindest einen Zwangsbedingung ermöglicht (1040).

5. Verfahren nach Anspruch 3 oder 4,
**dadurch gekennzeichnet, dass**
der Schritt zur Anzeige des Ergebnisses der Bewertung der zumindest einen Zwangsbedingung einen Schritt zur Anzeige zumindest eines Werts umfasst, wobei der Wert das Bestätigen der Position des ersten Objekts gemäß der zumindest einen Zwangsbedingung ermöglicht.

6. Verfahren nach einem der vorhergehenden Ansprüche,
**dadurch gekennzeichnet, dass**
das zumindest eine parametrische Modell, das eine Modellierung der zumindest einen Zwangsbedingung umfasst, in einem der parametrischen Modelle enthalten ist, die mit dem ersten und dem zweiten Objekt verknüpft sind.

7. Verfahren nach einem der Ansprüche 1 bis 5,
**dadurch gekennzeichnet, dass**
dieses zumindest eine Datenelement des zumindest einen parametrischen Modells, das eine Modellierung der zumindest einen Zwangsbedingung umfasst, von einem der parametrischen Modelle importiert wird (315), die mit dem ersten und zweiten Objekt verknüpft sind.

8. Verfahren nach einem der vorhergehenden Ansprüche,
**dadurch gekennzeichnet, dass**
das zweite Objekt zumindest einen Abschnitt eines Luftfahrzeuges umfasst.

9. Verfahren nach Anspruch 8,
**dadurch gekennzeichnet, dass**
die zumindest eine Zwangsbedingung mit zumindest einer der folgenden Positionen verbunden ist: der Position der Türen, der Position der Notrutschen, der Position des Bodens, der relativen Position des Bodens bei einer Seitenwindlandung und der relativen Position des Bodens bei einer Landung mit eingezogenem Bugfahrwerk.

10. Vorrichtung, die Mittel umfasst, welche zur Ausführung eines jeden der Schritte des Verfahrens nach einem der Ansprüche 1 bis 9 geeignet sind.

11. Computerprogramm, welches Befehle umfasst, die zur Ausführung eines jeden der Schritte des Verfahrens nach einem der Ansprüche 1 bis 9 geeignet sind.
